Europäisches Patentamt

European Patent Office

Office européen des brevets

(19)

(11) EP 1 193 877 A1

(12) **DEMANDE DE BREVET EUROPEEN**

(43) Date de publication:
**03.04.2002 Bulletin 2002/14**

(51) Int Cl.7: **H03L 7/197**, H03L 7/099,
H03J 5/02

(21) Numéro de dépôt: **01203619.0**

(22) Date de dépôt: **25.09.2001**

(84) Etats contractants désignés:
**AT BE CH CY DE DK ES FI FR GB GR IE IT LI LU
MC NL PT SE TR**
Etats d'extension désignés:
**AL LT LV MK RO SI**

(30) Priorité: **29.09.2000 FR 0012459
26.12.2000 FR 0017040**

(71) Demandeur: **Koninklijke Philips Electronics N.V.
5621 BA Eindhoven (NL)**

(72) Inventeur: **Jovenin, Fabrice
75008 Paris (FR)**

(74) Mandataire: **Chaffraix, Jean
Société Civile S.P.I.D.
156, Boulevard Haussmann
75008 Paris (FR)**

(54) **Synthétiseur de fréquences à diviseur fractionnaire et à réponse rapide, et procédé de synthèse de fréquences correspondant**

(57) La présente invention concerne un synthétiseur de fréquences, comportant, dans une boucle à verrouillage de phase :

- un comparateur phase-fréquence (16), connecté à une source de fréquences de référence (20),
- au moins un oscillateur commandé en tension (12), et
- un diviseur de fréquences fractionnaire (14) apte à fournir un rapport de division moyen avec une composante entière et une composante fractionnaire.

Conformément à l'invention, l'oscillateur comporte une pluralité d'étages d'oscillateur avec des fréquences centrales différentes, et le synthétiseur comporte en outre des moyens de sélection d'un étage d'oscillateur en fonction de la composante entière du rapport moyen de division.
Application aux téléphones portables.

FIG. 3

EP 1 193 877 A1

**Description**

Domaine technique

La présente invention concerne un synthétiseur de fréquences à diviseur fractionnaire et un procédé de synthèse de fréquences correspondant.

Elle concerne plus précisément un synthétiseur de fréquences autorisant un ajustage précis de la fréquence et capable de commuter rapidement entre plusieurs fréquences sélectionnées les unes après les autres.

Un tel synthétiseur de fréquences peut être utilisé dans différents types de circuits radioélectriques et en particulier dans des étages de réception et/ou d'émission de ces circuits. A titre d'exemple, le synthétiseur de fréquences de l'invention peut être utilisé dans des équipements de téléphonie sans fil, tels que les téléphones portables.

Etat de la technique antérieure

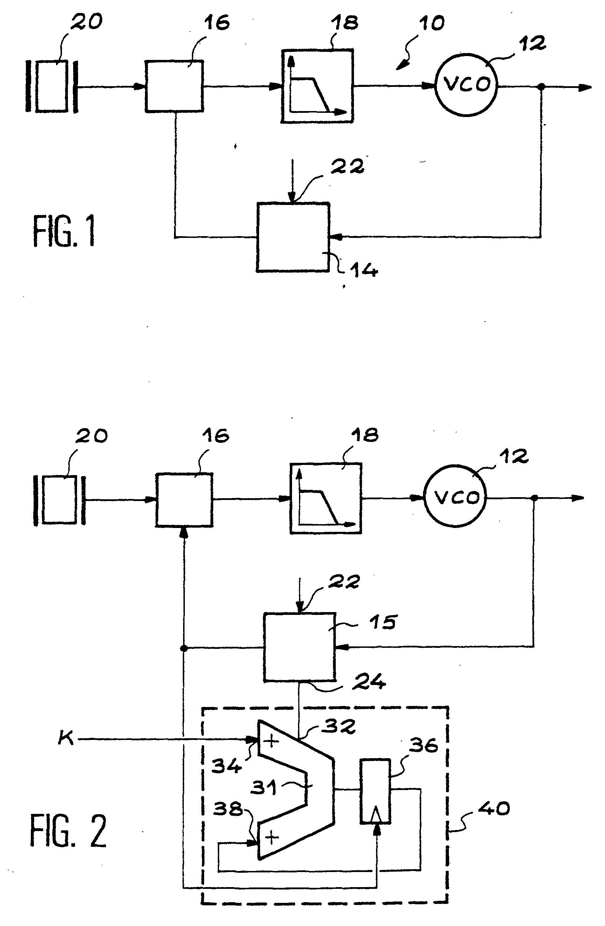

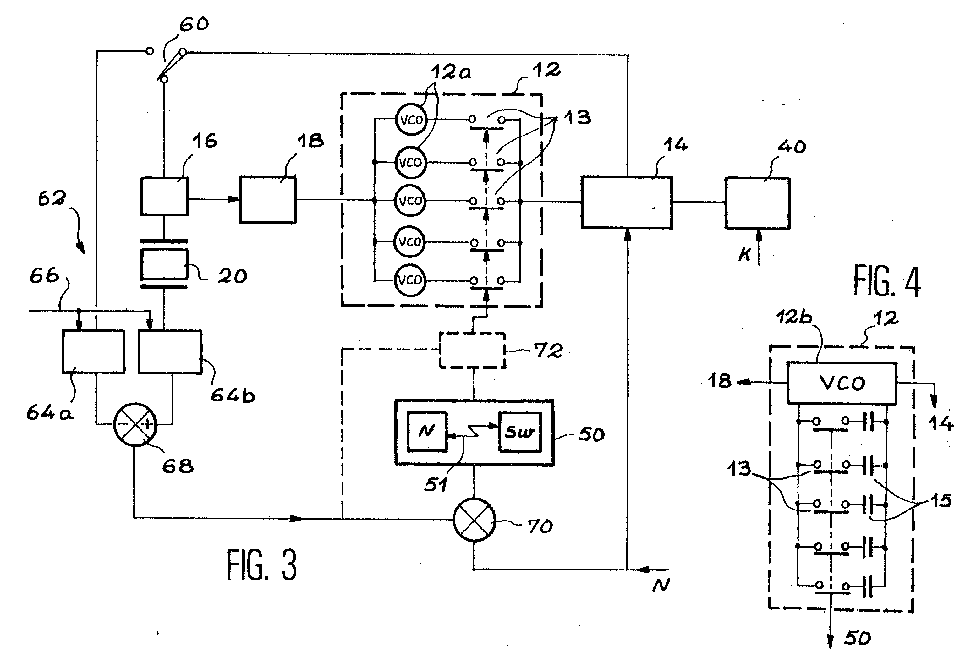

Les figures 1 et 2 annexées illustrent respectivement un synthétiseur de fréquences ajustable par valeurs entières, et un synthétiseur de fréquences ajustable par valeurs fractionnaires. On entend par synthétiseur de fréquences ajustable par valeurs fractionnaires, un synthétiseur de fréquences dont la fréquence peut être ajustée par multiples entiers ou non entiers d'une fréquence de référence. De tels dispositifs sont en soi connus et illustrés, par exemple, par les documents (1), (2) et (3) dont les références complètes sont précisées à la fin de la description.

La figure 1 indique la structure de base d'un synthétiseur de fréquences qui est construit autour d'une boucle à verrouillage de phase 10. La boucle à verrouillage de phase comporte pour l'essentiel un oscillateur commandé en tension 12, un diviseur de fréquences 14, un comparateur phase-fréquence 16 et un filtre de boucle 18.

L'oscillateur commandé en tension 12, désigné par « oscillateur VCO » dans la suite du texte, délivre un signal de sortie dont la fréquence peut être augmentée ou diminuée en fonction d'une tension de commande appliquée à son entrée. Cette tension de commande est fournie par le comparateur phase-fréquence 16 qui est relié à l'entrée de l'oscillateur VCO 12 par l'intermédiaire du filtre de boucle 18.

Le comparateur phase-fréquence 16 compare la fréquence (ou la phase) d'un signal délivré par le diviseur de fréquences 14 et la fréquence d'un signal de référence délivré, dans l'exemple de la figure, par un dispositif à quartz 20. Lorsque la fréquence du signal délivré par le diviseur de fréquences est inférieure à celle du signal de référence, le comparateur phase-fréquence, associé au filtre de boucle 18, fournit une tension commandant l'augmentation de la fréquence de l'oscillateur VCO 12. A l'inverse, la fréquence de l'oscillateur VCO est diminuée lorsque la fréquence du signal délivré par le diviseur de fréquences est supérieure à celle du signal de référence.

Le diviseur de fréquences 14 est un dispositif construit autour d'un certain nombre de bascules et ne peut donc diviser la fréquence du signal de l'oscillateur VCO 12 que par des valeurs entières. Le rapport de division, ajustable par valeurs entières, est un nombre entier noté N. Une entrée d'ajustage indiquée par une flèche 22 permet de fixer la valeur N.

La fréquence de l'oscillateur VCO, notée $F_{VCO}$ est donc telle que :

$$(1) \qquad F_{VCO} = N * F_{ref}$$

où $F_{ref}$ est la fréquence du signal de référence délivré par le dispositif à quartz 20.

On observe qu'une modification d'une unité de la valeur du rapport de division N (entier), provoque une variation égale à $F_{ref}$, de la fréquence de l'oscillateur VCO. Ainsi, il n'est pas possible d'ajuster la fréquence de l'oscillateur VCO 12 avec une résolution supérieure à $F_{ref}$. Or, dans la mesure où la fréquence du signal de référence est élevée, cette résolution peut s'avérer très insuffisante.

Un ajustage beaucoup plus fin de la fréquence du signal de sortie de la boucle 10, c'est à dire de la fréquence du signal délivré par l'oscillateur VCO 12, peut être obtenu avec un synthétiseur de fréquences conforme à la figure 2.

Le synthétiseur de fréquences de la figure 2 comprend une boucle à verrouillage de phase 10 avec les mêmes éléments que ceux de la boucle 10 de la figure 1.

Le diviseur de fréquences 14, en revanche, présente non seulement une entrée d'ajustage 22 pour fixer la valeur N du rapport de division, mais également une entrée de commutation 24 pour commuter le rapport de division entre deux ou plusieurs valeurs consécutives autour de la valeur N. Dans l'exemple de la figure 2, l'entrée de commutation 24 du diviseur de fréquences 14 permet de commuter le rapport de division entre deux valeurs qui sont N et N+1.

L'entrée de commutation 24 est reliée à un modulateur sigma-delta 30 et plus précisément à une borne 32 de retenue de dépassement (overflow) de ce modulateur.

Le modulateur sigma-delta 30, qui, dans l'exemple de la figure est un modulateur numérique d'ordre 1, avec un additionneur de mots 31, présente une première entrée numérique 34 pour une consigne d'ajustage notée K. La consigne d'ajustage est additionnée à une valeur numérique délivrée par un registre à décalage 36 du modulateur. Le registre 36 est cadencé par le signal de sortie du diviseur de fréquences 14, et reçoit la sortie de l'additionneur de mots 31. Il est relié à une deuxième entrée numérique 38 de l'additionneur. Lorsque la somme de la consigne d'ajustage et de la sortie du registre 36 est inférieure à la capacité numérique de l'additionneur 31, la retenue de dépassement prend la valeur logique 0, par exemple. En revanche, lorsque la somme est supérieure à la capacité de l'additionneur 31, la retenue prend la valeur logique complémentaire, 1 en l'occurrence.

Le diviseur de fréquences 14 est conçu de façon à effectuer une division de fréquences avec un premier rapport de division lorsque son entrée de commutation 24 reçoit le premier état logique et de façon à effectuer une division avec un deuxième rapport de division, différent de +/-1, lorsque l'entrée 24 reçoit le deuxième état de commutation.

Dans l'exemple décrit, le rapport de division est N pour un état logique 0 et est N+1 pour un état logique 1.

Bien qu'à tout instant le rapport de division du diviseur de fréquences soit un nombre entier, la commutation répétée du rapport entre N et N+1, permet d'obtenir un rapport de division moyen résultant compris entre ces deux valeurs, c'est à dire un rapport non entier.

De façon plus précise, on a :

$$Fvco = \frac{1}{T_N + T_{N+1}} [T_N * N * F_{ref} + T_{N+1} * (N + 1) * F_{ref}]$$

Soit

$$Fvco = \left[ N + \frac{T_{N+1}}{T_N + T_{N+1}} \right] * F_{ref}$$

Dans ces expressions $T_N$ et $T_{N+1}$ sont respectivement les périodes pendant lesquelles le rapport de division est égal à N et N+1.

En considérant que la consigne d'ajustage K appliquée à la première entrée 34 du modulateur sigma-delta est codée sur L bits, et que la capacité maximum de l'additionneur est de $2^L$-1, on peut définir une partie fractionnaire du rapport de division égale à $\frac{K}{2^L}$. La composante fractionnaire $\frac{K}{2^L}$ est encore notée k dans la suite du texte. On a :

$$(2) \qquad Fvco = \left[ N + \frac{K}{2^L} \right] * F_{ref}$$

Pour des valeurs faibles de la consigne d'ajustage (K≅0) la fréquence de sortie est voisine de $F_{ref}*(N)$ et pour des valeurs fortes de la consigne d'ajustage (K≅$2^L$), la fréquence de sortie est voisine de $F_{ref}*(N+1)$.

Il est ainsi possible d'ajuster continûment la fréquence de la boucle à verrouillage de phase entre deux valeurs fixées par le choix du rapport de division N appliquée à l'entrée d'ajustage 22 du diviseur de fréquences 14 et par le choix de la consigne d'ajustage K appliquée au modulateur sigma-delta.

Dans les boucles à verrouillage de phase classiques, conformes à la figure 1, la fréquence d'oscillation de l'oscillateur commandé en tension peut être ajustée par des « pas » de fréquence dont la valeur est $F_{ref}$. Le « pas » correspond alors à une variation du rapport de division de N à N+1 ou de N à N-1. Ceci apparaît clairement en se reportant à la formule (1) indiquée précédemment.

Afin d'obtenir toutefois un ajustage relativement précis de la fréquence de la boucle, la valeur de la fréquence $F_{ref}$ du signal de référence est choisie de préférence faible. A simple titre d'exemple, la fréquence $F_{ref}$, et donc le pas d'ajustage, peuvent être de l'ordre de 200kHz.

On peut noter également qu'une faible fréquence de référence conduit à retenir des valeurs N du rapport de division élevées. En effet, on rappelle que la fréquence de l'oscillateur commandé en tension est le produit de la fréquence de référence (relativement faible) par le rapport de division N (relativement élevé).

La contrainte du choix d'une valeur relativement faible pour la fréquence de référence n'existe toutefois pas dans une boucle à verrouillage de phase conforme à la figure 2.

La formule (2) donnée précédemment montre en effet qu'il est possible d'ajuster la fréquence en faisant varier la valeur de la partie fractionnaire k, c'est-à-dire $K/2^L$. Le pas d'ajustage peut donc être aussi fin que $F_{ref}/2^L$. Pour un codage sur 8 ou 16 bits, c'est-à-dire pour L=8 ou L=16, par exemple, l'ajustage peut être presque continu, et ce, de façon quasi indépendante de la fréquence de référence.

Ainsi pour des boucles à verrouillage de phase à diviseur fractionnaire, la fréquence de référence est préférentiellement choisie très élevée. Elle est par exemple de l'ordre de 26MHz. Une fréquence élevée permet en effet de corriger plus finement les dérives de la boucle et autorise ainsi une plus grande stabilité.

On peut encore noter que le choix d'une fréquence de référence relativement élevée permet de retenir des valeurs faibles de N, c'est-à-dire des valeurs faibles de la partie entière du rapport de division.

La pulsation propre de la boucle à verrouillage de phase, notée $\omega_n$ peut être exprimée en fonction du gain $K_{VCO}$ de l'oscillateur 12 commandé en tension, du gain $K_\phi$ d'une pompe de charge du comparateur phase-fréquence 16, de la capacité C d'un condensateur du filtre de boucle 18, et de la partie entière N du rapport de division du diviseur 22. La relation est la suivante :

$$(3) \qquad \omega_n = \sqrt{\frac{K_{VCO} \cdot K_\phi}{N \cdot C}}$$

De la valeur $\omega_n$ de la pulsation de la boucle dépend aussi le temps de commutation $t_s$ de la boucle à verrouillage de phase. Le temps de commutation $t_s$ peut être compris comme le temps nécessaire à la boucle pour s'établir à un régime d'oscillation de pulsation donnée ou le temps nécessaire pour commuter d'une valeur de pulsation ou de fréquence à une autre.

Le temps de commutation $t_s$ est relié à la pulsation par la relation suivante :

$$t_s = (2,5\text{x}2\text{x}\pi)/\omega_n$$

En se reportant encore à la formule (3) de la pulsation $\omega_n$ indiquée ci-dessus, on constate qu'à pulsation égale, des valeurs relativement faibles du rapport de division N, ou tout au moins de sa partie entière, doivent être compensées par des valeurs relativement fortes de la capacité C du filtre de boucle. En effet, les valeurs $K_{VCO}$ et $K_\phi$ sont des constantes liées à l'oscillateur et à la pompe de charge du comparateur phase-fréquence.

Le choix d'une capacité forte pour le filtre de boucle fait apparaître l'influence d'un autre paramètre temporel t qui est le temps de charge de cette capacité. Le filtre de boucle peut être considéré comme un filtre passe bande avec un condensateur capable de convertir un courant i, non filtré en fréquence, de la pompe de charge du convertisseur phase-fréquence en une tension $V_{tune,}$ filtrée en fréquence, et utilisée pour commander l'oscillateur VCO. Le temps t de charge de la capacité C, est lié au courant i et à la tension $V_{tune}$ par la relation suivante :

$$(4) \qquad t = C\text{x}V_{tune}/i$$

Dans cette expression C est la capacité du filtre de boucle.

Le temps de charge t de la capacité vient s'ajouter au temps de commutation ts évoqué précédemment et est susceptible de pénaliser la vitesse d'accord de la boucle à une fréquence souhaitée. Ce problème est spécifique aux boucles comprenant un diviseur fractionnaire c'est-à-dire aux boucles pilotées par une fréquence de référence élevée et présentant un rapport de division N faible.

L'état de la technique est encore illustré par des documents dont les références sont précisées à la fin de la description.

Exposé de l'invention

L'invention a pour but de proposer un synthétiseur de fréquences et un procédé de synthèse de fréquences correspondant, ne présentant pas les limitations évoquées ci-dessus.

Un but est en particulier de proposer un synthétiseur de fréquences du type à diviseur fractionnaire, capable de fonctionner avec une fréquence de référence élevée, et présentant un temps de commutation global très court.

Un autre but de l'invention est de proposer un tel synthétiseur dans lequel il n'est pas nécessaire de recourir à une multiplication du nombre de pompes de charges ou au surdimensionnement de la pompe de charge équipant le convertisseur phase-fréquence d'une boucle à verrouillage de phase.

Un but de l'invention est encore de proposer un tel synthétiseur qui soit affranchi, dans une large mesure, de la dispersion de caractéristiques des composants et de l'influence de dérives thermiques.

Pour atteindre ces buts, l'invention a plus précisément pour objet un synthétiseur de fréquences comportant, dans une boucle à verrouillage de phase :

- un comparateur phase-fréquence, connecté à une source de fréquences de référence,
- au moins un oscillateur commandé en tension, et
- un diviseur de fréquences fractionnaire apte à fournir un rapport de division moyen avec une composante entière et une composante fractionnaire, le diviseur de fréquences étant connecté entre l'oscillateur commandé en tension et le comparateur phase-fréquence.

Conformément à l'invention, l'oscillateur commandé en tension comporte une pluralité d'étages d'oscillateur avec des fréquences centrales différentes, et le synthétiseur comporte des moyens de sélection d'un étage d'oscillateur en fonction de la composante entière du rapport moyen de division.

L'invention s'applique en particulier à des synthétiseurs de fréquences dans lesquels une fréquence d'un signal fourni par la source de fréquences de référence est supérieure, et même très supérieure, aux pas d'ajustage en fréquence autorisés par le diviseur de fréquences. Ceci est le cas pour les synthétiseurs de fréquences avec un diviseur fractionnaire.

En multipliant le nombre d'étages de VCO, et en sélectionnant l'un des étages il est possible d'attribuer à chaque étage une fréquence centrale différente et donc une bande de fréquences d'oscillation différente. Ces bandes de fréquences d'oscillation, encore appelées bandes passantes, peuvent donc être moins larges que celles de l'oscillateur complet ou celles de l'oscillateur des dispositifs de l'art antérieur. Or, en conservant la tension de commande $V_{tune}$ inchangée, et en utilisant cette tension pour la commande d'étages d'oscillateur avec des bandes passantes plus étroites, le gain $K_{VCO}$ des différents étages peut être réduit. En effet le gain d'un oscillateur VCO ou d'un étage d'oscillateur VCO, est compris comme le rapport entre la variation de la fréquence à celle de la tension de commande ($V_{tune}$).

En se reportant à l'expression (3) de la pulsation de la boucle à verrouillage de phase donnée dans la partie introductive du texte, on constate qu'une diminution du gain $K_{VCO}$ autorise, à valeur de pulsation égale, une diminution de la valeur de la capacité C du filtre de boucle. Or une capacité C plus faible permet de réduire le temps t de charge. On peut se reporter à ce sujet à l'équation (4) également donnée dans la partie introductive.

En se référant toujours à cette même formule, on observe qu'une augmentation du courant i aurait abouti également à une réduction du temps de charge t. En revanche cette autre solution, non retenue par l'invention, aurait nécessité une nouvelle conception de la pompe de charge du comparateur phase-fréquence pour augmenter l'intensité du courant i qu'elle délivre.

On peut noter par ailleurs que les différents étages de l'oscillateur commandé en tension présentent des temps de commutation très courts, non seulement en raison de leur gain limité, mais aussi en raison du fait que la fréquence du signal qu'ils sont susceptibles de délivrer est généralement plus proche de leur fréquence centrale, qu'elle ne le serait d'un oscillateur à étage unique.

Bien que ce ne soit pas une condition absolument nécessaire au fonctionnement du synthétiseur, il est toutefois souhaitable que les bandes passantes des étages d'oscillateur commandés en tension soient consécutives en présentant deux à deux un recouvrement.

L'oscillateur commandé en tension peut comporter un oscillateur VCO unique associé à une batterie de condensateurs ou de varactors servant à la sélection de la fréquence centrale. On désigne par varactor un composant dont la capacité peut être ajustée par une tension de commande. Chaque condensateur ou varactor forme alors avec l'oscillateur VCO un des étages d'oscillateur. Selon une variante l'oscillateur commandé en tension peut aussi comporter une pluralité d'oscillateurs VCO autonomes présentant respectivement des fréquences centrales différentes et formant respectivement les différents étages. Les fréquences peuvent dans ce cas être fixées également par des condensateurs associés aux différents VCO.

Dans une réalisation particulière du synthétiseur de l'invention, les moyens de sélection des étages de l'oscillateur peuvent comporter une table logique reliant respectivement les parties entières du rapport de division sélectionnées pour le diviseur de fréquences, à des choix d'étages de l'oscillateur commandé en tension.

Les moyens de sélection peuvent également comporter un pointeur logique piloté par une donnée correspondant à la partie entière du rapport de division, pour sélectionner, à partir de la table logique, un étage de l'oscillateur commandé en tension.

La table logique peut comporter des valeurs logiques, par exemple sous la forme de codes binaires, associés à des valeurs de N, et utilisables pour commander l'ouverture ou la fermeture d'interrupteurs. Les interrupteurs sont alors prévus soit pour commuter l'un des étages formés d'un VCO autonome dans la boucle à verrouillage de phase, soit pour sélectionner un ou plusieurs condensateurs d'une batterie de condensateurs pour modifier la fréquence centrale d'un VCO. Les codes binaires peuvent également être utilisés pour une commande en tension de varactors.

Selon une réalisation perfectionnée du synthétiseur de l'invention, celui-ci peut comporter des moyens de calibrage associés aux moyens de sélection des étages de l'oscillateur commandé en tension. Grâce au calibrage, le synthétiseur peut être affranchi des dispersions de caractéristiques des oscillateurs VCO qui peuvent résulter de la fabrication de ces composants, ou de leur sensibilité à la température. Le calibrage peut intervenir à la mise sous tension du dispositif, ou éventuellement à chaque changement de fréquence. Les moyens de calibrage peuvent comporter, par exemple, un premier et un deuxième compteurs cadencés respectivement par l'oscillateur commandé en tension et par la source de fréquence de référence, un soustracteur connecté aux compteurs pour établir une différence de comptage, et des moyens de correction de la sélection en fonction de la différence de comptage.

L'utilisation de deux compteurs est une solution particulièrement économique et fiable pour contrôler la fréquence des étages du VCO. Elle permet en outre d'établir directement une consigne de correction qui est la différence de comptage.

Pour prendre en compte la consigne de correction, les moyens de calibrage peuvent comporter un additionneur pour additionner la différence de comptage à la valeur entière du rapport de division moyen N et pour appliquer cette somme à la table logique de sélection des étages de l'oscillateur commandé en tension. Les moyens de calibrage peuvent aussi comporter un registre de décalage des valeurs numériques de sélection des étages de l'oscillateur commandés en tension, lues dans la table logique de sélection.

L'invention concerne également un procédé de synthèse de fréquences au moyen d'un synthétiseur de fréquences, comportant, dans une boucle à verrouillage de phase :

- un comparateur phase-fréquence, connecté à une source de fréquences de référence,
- au moins un oscillateur commandé en tension, et
- un diviseur de fréquences fractionnaire apte à fournir un rapport de division moyen avec une composante entière et une composante fractionnaire, le diviseur de fréquences étant connecté entre l'oscillateur commandé en tension et le comparateur phase-fréquence,

dans lequel l'oscillateur commandé en tension comporte une pluralité d'étages d'oscillateur avec des fréquences centrales différentes. Conformément au procédé, on sélectionne l'un des étages d'oscillateur commandé en tension en fonction de la valeur entière du rapport de division moyen.

Enfin, l'invention concerne un convertisseur de fréquences équipé du synthétiseur de fréquences conforme à l'invention, et son utilisation dans un téléphone portable.

D'autres caractéristiques et avantages de l'invention ressortiront de la description qui va suivre, en référence aux figures des dessins annexés. Cette description est donnée à titre purement illustratif et non limitatif.

Brève description des figures.

La figure 1, déjà décrite, est un schéma de principe simplifié d'un synthétiseur de fréquences connu, à ajustage de fréquence discret.

La figure 2, déjà décrite, est un schéma de principe simplifié d'un synthétiseur de fréquences connu, à ajustage de fréquence continu.

La figure 3, est un schéma simplifié d'un synthétiseur de fréquences conforme à l'invention.

La figure 4 est une représentation schématique simplifiée d'un oscillateur commandé en tension utilisable dans un synthétiseur de fréquences conforme à l'invention et constituant une variante d'un oscillateur utilisé dans le dispositif de la figure 3.

La figure 5 est une représentation schématique simplifiée d'un convertisseur de fréquences utilisant un synthétiseur de fréquences conforme à l'invention.

Description détaillée de modes de mise en oeuvre de l'invention.

Dans la description qui suit, des parties des figures 3, 4 et 5 qui sont identiques similaires ou équivalentes à celles des figures déjà décrites sont repérées par les mêmes références numériques. On peut ainsi se reporter à leur sujet à la description qui précède, en référence aux figures 1 et 2.

L'oscillateur à étage unique des figures 1 et 2 est remplacé sur la figure 3 par un oscillateur commandé en tension 12 présentant une pluralité d'étages d'oscillateur. Chaque étage comporte un oscillateur VCO autonome 12a. Ceux-ci sont connectés en parallèle entre le filtre de boucle 18 et le diviseur de fréquences 14. Chaque étage comporte par ailleurs un interrupteur 13 capable de mettre l'oscillateur 12a en circuit ou hors circuit. L'actionnement des interrupteurs est piloté par des moyens de sélection décrits ultérieurement. Ils permettent de sélectionner un seul oscillateur 12a à la fois.

Dans l'exemple décrit, chaque oscillateur 12a présente une bande passante et une fréquence centrale qui lui sont propres. On entend par bande passante la gamme de fréquences que l'oscillateur 12a, de type VCO, est susceptible de délivrer en faisant varier la tension de commande délivrée par le comparateur phase-fréquence et le filtre de boucle d'une valeur minimum à une valeur maximum. La fréquence centrale est la fréquence de milieu de bande obtenue en appliquant comme tension de commande environ la moitié de la tension maximum. Par ailleurs, les fréquences centrales des oscillateurs des différents étages présentent une progression arithmétique et les bandes passantes présentent un recouvrement.

Comme indiqué dans la partie introductive, les deux paramètres de commande essentiels du synthétiseur de fréquences sont la partie entière N du rapport de division, et la partie fractionnaire qui est commandée par une consigne d'ajustage K appliquée au modulateur sigma-delta 40.

La valeur N est appliquée directement au diviseur de fréquences 14, mais aussi à une table logique 50. Un pointeur 51 de la table logique permet de sélectionner, en fonction de la valeur N, une consigne numérique de commande des interrupteurs 13.

Le tableau I ci-après donne un exemple de corresponsdance entre les valeurs de N, la consigne logique de commande des interrupteurs et l'étage d'oscillateur sélectionné. Les étages sont indiqués par $VCO_0$ à $VCO_6$, ce qui correspond à 7 oscillateurs commandés en tension. Le tableau indique en outre l'étendue des gammes de fréquences d'oscillation des différents étages lorsque la tension de commande, c'est à dire $V_{tune}$ varie de 0.4 à 3.8 Volt. Les fréquences sont exprimées en mégahertz. La tension de commande délivrée par le filtre de boucle varie généralement de 0, à 4 Volt mais peut, comme dans cet exemple, être limité à une gamme un peu plus restreinte. Le tableau I ne correspond pas exactement à la figure 3 sur laquelle seuls cinq étages d'oscillateur sont représentés pour des raisons de clarté.

TABLEAU I

| N | ≤8 | 9 à 14 | 11 à 17 | 14 à 20 | 18 à 23 | 21 à 27 | ≥ 28 |
|---|---|---|---|---|---|---|---|
| consigne | "0000,00" | "0000,01" | "0001,01" | "0011,01" | "0111,01" | "1111,01" | "1111,11" |
| freq@0.4V | 1,757 | 1,787 | 1,817 | 1,858 | 1,893 | 1,939 | |
| Freq@3.8V | | 1,842 | 1,876 | 1,921 | 1,960 | 2,012 | 2,069 |
| Etage | $VCO_0$ | $VCO_1$ | $VCO_2$ | $VCO_3$ | $VCO_4$ | $VCO_5$ | $VCO_6$ |

De même, le tableau I ne coïncide pas exactement avec le contenu de la table de correspondance 50. On peut en effet observer qu'à certaines valeurs de N peuvent correspondre plusieurs étages d'oscillateur. Ce recouvrement, qui se traduit aussi par un recouvrement des gammes de fréquences susceptibles d'être générées par les étages d'oscillateur, permet de compenser, lors d'une correction examinée ultérieurement, une dérive de caractéristiques des étages d'oscillateur. Lorsque deux étages d'oscillateur peuvent fournir une même fréquence d'oscillation, en réponse à une valeur N, la table de correspondance 50 peut être programmée, par exemple, pour retenir l'étage pour lequel la fréquence en question est la plus proche de la fréquence centrale.

La table de correspondance peut comporter une mémoire ROM (mémoire à lecture seule), programmée par construction, ou éventuellement une mémoire programmable de type EPROM.

En fonctionnement normal de la synthèse de fréquences, la sortie du diviseur de fréquences est reliée à l'entrée du comparateur phase-fréquence 16. Toutefois un commutateur 60 permet, lors de la mise sous tension, ou même lors de chaque modification de la valeur N de la partie entière du rapport de division, d'envoyer le signal divisé en fréquence vers un étage de calibrage 62.

L'étage de calibrage comporte deux compteurs sensiblement identiques 64a et 64b. Le premier compteur 64a est relié, par l'intermédiaire de l'interrupteur 60 à la sortie du diviseur de fréquences 14. Le deuxième compteur 64b, en revanche est directement relié au quartz de la source 20 de fréquences de référence. Une commande de synchronisation 66 permet de déclencher simultanément le début et la fin du comptage des deux compteurs 64a et 64b.

En principe, lorsque les étages d'oscillation sont parfaitement calibrés et qu'ils oscillent à la fréquence sélectionnée par le choix de N, aucune différence ne devrait exister entre le résultat de comptage des deux compteurs. En effet si $F_{VCO}$, la fréquence d'oscillation de l'étage d'oscillateur sélectionné est tel que $F_{VCO}=F_{ref}*N$, on devrait obtenir à la sortie du diviseur, c'est-à-dire à l'entrée du premier compteur, une fréquence de $F_{VCO}/N$ soit $F_{ref}$ qui est la fréquence de la source de fréquences de référence. On considère ici que pendant une phase de calibrage, une composante fractionnaire k est maintenue nulle.

En revanche, si une différence de comptage existe entre les deux compteurs, une correction peut être effectuée. Une différence Mb-Ma est établie par un soustracteur 68, connecté aux sorties des deux compteurs 64a et 64b. Ma et Mb indiquent ici les valeurs de comptage des deux compteurs obtenus au terme d'un temps de comptage Δt séparant les commandes de synchronisation de début et de fin de comptage.

Dans l'exemple décrit, l'erreur minimum entre la somme obtenue par les deux compteurs est de 1, ce qui correspond à une erreur en fréquence de une fois la valeur de la fréquence de référence $F_{ref}$. En d'autres termes on a :

$$F_{VCO}=(N+\Delta N)*F_{ref}$$

où $\Delta N$ est l'erreur de fréquence de l'oscillateur rapportée à une variation du rapport de division. On peut aussi écrire :

$$Min\ |Mb-Ma| = \Delta t * Fref/N*Min(\Delta N)$$

Dans cette expression Min désigne le minimum.

La valeur de $Min(\Delta N)$, qui n'est pas nécessairement entière, peut être choisie de préférence en fonction de l'importance du recouvrement entre les gammes de fréquences et donc les gammes de rapports de division associées aux différents étages d'oscillateur. Du choix de $\Delta N$ dépend aussi celui de $\Delta t$.

Dans l'exemple décrit ici on choisit $\Delta N=1$ et donc $\Delta t=F_{ref}/N$ (avec $Min|Mb-Ma|=1$).

Le temps $\Delta t$ est faible devant les temps t et $t_s$ indiqués dans la partie introductive de la description. A simple titre d'exemple, on peut avoir $\Delta t=20\mu sec$ pour $t_s=100\mu sec$ et $t=1000\mu sec$.

Le soustracteur 68 est relié à un additionneur 70, prévu à l'entrée de la table logique 50 pour ajouter à la sélection de la valeur N la différence Mb-Ma. Ceci permet de prendre en compte l'erreur de comptage pour la sélection de l'étage de l'oscillateur. Il convient de noter que la valeur N appliquée au diviseur 14 est maintenue inchangée.

Selon une autre possibilité, représentée en trait discontinu, la correction liée à la différence de comptage peut aussi être prise en compte à la sortie de la table 50. Dans ce cas toutefois, la différence de comptage doit être traduite en une modification des consignes logiques (Sw) de commande des interrupteurs. Cette opération est exécutée par un registre 72.

A la fin de la phase de calibrage, une nouvelle commutation de l'interrupteur 60 permet de refermer la boucle jusqu'à la sélection d'une nouvelle valeur de N ou jusqu'à la sélection d'une valeur de N susceptible de modifier le choix de l'étage d'oscillateur VCO.

La figure 4, brièvement décrite ci après montre une autre possibilité de réalisation de l'oscillateur 12 commandé en tension. Dans l'exemple de cette figure, un unique oscillateur VCO 12b (commandé en tension) est relié à une batterie de condensateurs 15 connectés en parallèle. Les condensateurs 15, prévus pour choisir la fréquence centrale et la bande de fréquences d'oscillation de l'oscillateur unique, sont en série avec des interrupteurs 13. L'ouverture et la fermeture de ces interrupteurs sont commandées par des codes logiques établis dans une table de correspondance du même type que celle décrite en relation avec la figure 3. On peut noter toutefois qu'à la différence du précédent mode de réalisation plusieurs interrupteurs peuvent être fermés simultanément.

Il convient de préciser que chaque interrupteur associé à un condensateur peut correspondre à une ligne de varactor. La fermeture et l'ouverture de l'interrupteur symbolise alors l'application ou non d'une tension de commande à l'entrée du varactor.

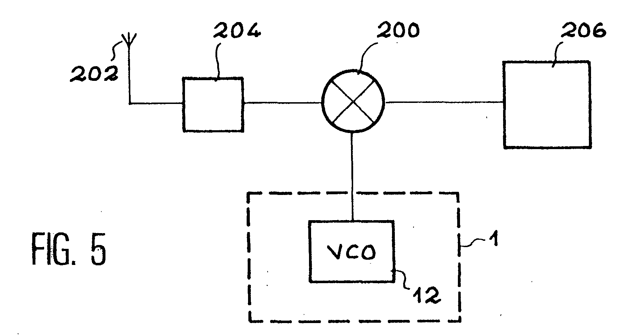

La figure 5 montre une application d'un synthétiseur de fréquences conforme à l'invention à la réalisation d'un convertisseur de fréquences et plus précisément à un convertisseur de fréquences dans un émetteur-récepteur de signaux.

Le convertisseur comprend un mélangeur auquel est connecté d'une part une source de signal à convertir, par exemple une antenne 202 associée à un filtre 204, et d'autre part une unité de traitement 206. L'unité de traitement 206 reçoit le signal dont la fréquence est convertie. Il s'agit, par exemple, d'une unité de traitement d'un téléphone portable.

Le mélangeur 200 reçoit également un signal de fréquence de référence d'une deuxième source de signal qui, dans l'exemple décrit, provient d'un oscillateur VCO 12 d'un synthétiseur de fréquences 1 conforme à l'invention.

Documents cités :

(1)
EP-B-0 661 816
(2)
EP-A-0 563 400
(3)
"Fractional-N PII using delta-sigma modulation" de Thomas Stichelbout, Aalborg University, August 5, 1997, pages 1 à 21.
(4)
WO 89/06456

(5)
EP-A-0 910 170
(6)
EP-A-0 664 616
(7)
EP-A-0 944 171
(8)
US-5 053 723
(9)
US-5 648 744.


**Revendications**

1.  Synthétiseur de fréquences, comportant, dans une boucle à verrouillage de phase :

    -   un comparateur phase-fréquence (16), connecté à une source de fréquences de référence (20),
    -   au moins un oscillateur commandé en tension (12), et
    -   un diviseur de fréquences fractionnaire (14) apte à fournir un rapport de division moyen avec une composante entière et une composante fractionnaire, le diviseur de fréquences étant connecté entre l'oscillateur commandé en tension (12) et le comparateur phase-fréquence (16),

    **caractérisé en ce que** l'oscillateur commandé en tension comporte une pluralité d'étages d'oscillateur avec des fréquences centrales différentes, et **en ce que** le synthétiseur comporte en outre des moyens de sélection (13, 50) d'un étage d'oscillateur en fonction de la composante entière du rapport moyen de division.

2.  Synthétiseur selon la revendication 1, dans lequel une fréquence d'un signal fourni par la source de fréquences de référence est supérieure à un pas d'ajustage en fréquence du diviseur de fréquences.

3.  Synthétiseur selon la revendication 1, dans lequel les moyens de sélection comportent une table logique (50) reliant respectivement les parties entières du rapport de division du diviseur de fréquences à des choix d'étages de l'oscillateur commandé en tension.

4.  Synthétiseur selon la revendication 3, dans lequel les moyens de sélection comportent un pointeur logique (51) piloté par une donnée correspondant à la partie entière du rapport de division, et associé à la table logique pour sélectionner un étage de l'oscillateur commandé en tension.

5.  Synthétiseur selon la revendication 3, comportant des interrupteurs (13) de sélection des étages de l'oscillateur commandé en tension, et dans lequel la table logique (50) contient des valeurs logiques de commande des interrupteurs.

6.  Synthétiseur selon la revendication 1, dans lequel chaque étage de l'oscillateur commandé en tension comporte un oscillateur commandé en tension autonome (12a) avec une fréquence centrale propre.

7.  Synthétiseur selon la revendication 1, comprenant un oscillateur commandé en tension unique (12b) associé à une batterie de condensateurs de sélection (15) de la fréquence centrale, chaque condensateur formant en association avec l'oscillateur unique un étage d'oscillateur commandé en tension.

8.  synthétiseur selon la revendication 1, comprenant un oscillateur commandé en tension unique (12) associé à au moins un varactor.

9.  Synthétiseur selon la revendication 1, comprenant, en outre, des moyens de calibrage (64a, 64b, 66, 68, 70, 72) de la sélection des étages de l'oscillateur commandé en tension.

10. Synthétiseur selon la revendication 1, dans lequel les fréquences centrales des étages de l'oscillateur commandé en tension répondent à une progression arithmétique et dans lequel les moyens de calibrage comportent un premier et un deuxième compteurs (64a, 64b), cadencés respectivement par l'oscillateur commandé en tension (12) associé au diviseur de fréquences (14), et par la source de fréquence de référence (20), un soustracteur (68) connecté aux compteurs pour établir un différence de comptage, et des moyens (70, 72) de correction de la sélection en fonction de la différence de comptage.

**11.** Synthétiseur selon la revendication 10, dans lequel les moyens de correction comportent un additionneur (70) pour additionner la différence de comptage à la valeur entière du rapport de division moyen et pour appliquer cette somme à un pointeur de sélection (51) d'une table logique (50) de sélection des étages de l'oscillateur commandé en tension.

**12.** Synthétiseur de fréquences selon la revendication 10, dans lequel, les moyens de correction comportent un registre (70) de décalage de valeurs numérique de sélection d'un étage de l'oscillateur commandé en tension, lues dans une table logique de sélection (50).

**13.** Procédé de synthèse de fréquences au moyen d'un synthétiseur de fréquences, comportant, dans une boucle à verrouillage de phase :

- un comparateur phase-fréquence (16), connecté à une source de fréquences de référence (20),
- au moins un oscillateur commandé en tension (12), et
- un diviseur de fréquences fractionnaire (14) apte à fournir un rapport de division moyen avec une composante entière et une composante fractionnaire, le diviseur de fréquences étant connecté entre l'oscillateur commandé en tension et le comparateur phase-fréquence,

dans lequel l'oscillateur commandé en tension comporte une pluralité d'étages d'oscillateur avec des fréquences centrales différentes, procédé dans lequel on sélectionne l'un des étages de l'oscillateur commandé en tension en fonction de la valeur entière du rapport de division moyen du diviseur de fréquences.

**14.** Procédé selon la revendication 13, dans lequel on sélectionne l'étage au moyen d'une table de correspondance logique (50).

**15.** Procédé selon la revendication 13, comprenant une étape de calibrage de la sélection, lors de laquelle la boucle à verrouillage de phase est ouverte, et une étape de synthèse de fréquences lors de laquelle la boucle de verrouillage de phase est fermée.

**16.** Procédé selon la revendication 15, comportant une étape de calibrage lors d'une mise sous tension du synthétiseur de fréquences.

**17.** Procédé selon la revendication 15, comportant en outre une étape de calibrage lors de chaque nouvelle sélection d'un rapport de division.

**18.** Convertisseur de fréquences comprenant un mélangeur (200) avec une première entrée connectée à une première source de signal (202, 204) délivrant un signal avec une fréquence à convertir, et comprenant une deuxième source de signal (1) avec une fréquence de référence, la deuxième source étant reliée à une deuxième entrée du mélangeur, **caractérisé en ce que** la deuxième source de signal (1) avec une fréquence de référence comprend un synthétiseur de fréquences (12) conforme à la revendication 1.

**19.** Utilisation d'un convertisseur de fréquences selon la revendication 18 dans un téléphone portable.

FIG. 1

FIG. 2

FIG. 3

FIG. 4

EP 1 193 877 A1

FIG. 5

EP 1 193 877 A1

**Office européen des brevets**

**RAPPORT DE RECHERCHE EUROPEENNE**

Numéro de la demande

EP 01 20 3619

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | EP 0 874 463 A (MATSUSHITA ELECTRIC IND CO LTD) 28 octobre 1998 (1998-10-28) * page 5, ligne 22 - page 6, ligne 32 * * page 4, ligne 12 - ligne 55 * * figures 2-6 * | 1,2,6, 13,18,19 | H03L7/197 H03L7/099 H03J5/02 |
| X | US 4 893 087 A (DAVIS WALTER L) 9 janvier 1990 (1990-01-09) * colonne 1, ligne 43 - colonne 3, ligne 11; figures * | 1,3-5, 7-9,13, 14,18,19 | |
| X | DE 298 09 632 U (SIEMENS AG) 8 octobre 1998 (1998-10-08) * page 1, ligne 5 - ligne 11 * * page 3, ligne 24 - page 6, ligne 16; figures 1-4 * | 1,3-9, 13,14, 18,19 | |
| X | US 4 057 760 A (KOCH RICHARD C) 8 novembre 1977 (1977-11-08) * colonne 3, ligne 28 - colonne 7, ligne 62; figures 1A,1B * | 1,3-6, 13,14,18 | DOMAINES TECHNIQUES RECHERCHES (Int.Cl.7) H03L |
| X | US 6 112 068 A (BACON WILLIAM A ET AL) 29 août 2000 (2000-08-29) * colonne 3, ligne 21 - colonne 7, ligne 51; figures * | 1,6,13, 18,19 | |
| X | PATENT ABSTRACTS OF JAPAN vol. 009, no. 089 (E-309), 18 avril 1985 (1985-04-18) & JP 59 218045 A (YAESU MUSEN KK), 8 décembre 1984 (1984-12-08) * abrégé * | 1,3-5,7, 13,14 | |

Le présent rapport a été établi pour toutes les revendications

| Lieu de la recherche | Date d'achèvement de la recherche | Examinateur |
|---|---|---|
| LA HAYE | 7 janvier 2002 | Balbinot, H |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

**ANNEXE AU RAPPORT DE RECHERCHE EUROPEENNE
RELATIF A LA DEMANDE DE BREVET EUROPEEN NO.**

EP 01 20 3619

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

07-01-2002

| Document brevet cité au rapport de recherche | | | Date de publication | Membre(s) de la famille de brevet(s) | | Date de publication |
|---|---|---|---|---|---|---|
| EP 0874463 | A | | 28-10-1998 | JP | 10303747 A | 13-11-1998 |
| | | | | CN | 1202042 A | 16-12-1998 |
| | | | | EP | 0874463 A2 | 28-10-1998 |
| | | | | US | 6229399 B1 | 08-05-2001 |
| US 4893087 | A | | 09-01-1990 | AU | 3033689 A | 01-08-1989 |
| | | | | EP | 0394358 A1 | 31-10-1990 |
| | | | | WO | 8906456 A1 | 13-07-1989 |
| DE 29809632 | U | | 08-10-1998 | DE | 29809632 U1 | 08-10-1998 |
| US 4057760 | A | | 08-11-1977 | AUCUN | | |
| US 6112068 | A | | 29-08-2000 | AUCUN | | |
| JP 59218045 | A | | 08-12-1984 | AUCUN | | |

EPO FORM P0460

Pour tout renseignement concernant cette annexe : voir Journal Officiel de l'Office européen des brevets, No.12/82